# EUROPÄISCHE PATENTSCHRIFT

(11) **EP 3 652 609 B1**
(45) Veröffentlichungstag und Bekanntmachung des Hinweises auf die Patenterteilung: **29.06.2022**
(21) Anmeldenummer: 19721287.1
(22) Anmeldetag: 02.05.2019
(51) Int. Cl.: G06F 1/18

(54) **COMPUTERSYSTEM, HALTEVORRICHTUNG UND MONTAGEVERFAHREN FÜR EINE ZUSATZPLATINE IN EINEM COMPUTERSYSTEM**
COMPUTER SYSTEM, HOLDING DEVICE AND MOUNTING METHOD FOR AN ADDITIONAL CIRCUIT BOARD IN A COMPUTER SYSTEM
SYSTÈME INFORMATIQUE, DISPOSITIF DE MAINTIEN ET PROCÉDÉ DE MONTAGE POUR UNE PLATINE COMPLÉMENTAIRE DANS UN SYSTÈME INFORMATIQUE

(30) Priorität: 18.07.2018 DE 102018117382
(43) Veröffentlichungstag der Anmeldung: 20.05.2020
(73) Patentinhaber: Fujitsu Client Computing Limited, Kawasaki-shi, Kanagawa 211-8588 (JP)
(72) Erfinder: JIANG, Albert, Nangang District Taipei (TW); SCHMID, Michael, 80807 München (DE); LUGERT, Harald, 80807 München (DE); STERZIK, Willi, 80807 München (DE); KRAUTER, Matthias, 80807 München (DE)
(74) Vertreter: Epping - Hermann - Fischer
(86) Internationale Anmeldenummer: PCT/EP2019/061278
(87) Internationale Veröffentlichungsnummer: WO 2020/015879

(56) Entgegenhaltungen:
- WO-A1-2015/007045
- CN-A- 101 236 450

## Beschreibung

Die vorliegende Erfindung betrifft ein Computersystem umfassend ein Gehäuse mit wenigstens einer Gehäusewand, wobei die wenigstens eine Gehäusewand eine Aussparung zur Anbringung einer Zusatzplatine aufweist. Ferner betrifft die Erfindung eine Haltevorrichtung und ein Montageverfahren für eine Zusatzplatine in einem Computersystem.

Computergehäuse weisen gewöhnlich Aussparungen in Gehäusewänden auf, in denen Zusatzplatinen, wie beispielsweise PCI-(Peripheral Component Interconnect) bzw. PCIe-(Peripheral Component Interconnect Express) Karten, in ein Computersystem eingebaut werden können. Bei solchen PCI- bzw. PCIe-Karten handelt es sich beispielsweise um Netzwerkkarten oder Grafikkarten. Derartige Zusatzplatinen weisen unterschiedliche Formfaktoren auf. So gibt es beispielsweise so genannter Low-Profile-Platinen, deren Slotblenden eine Höhe von 79,2 mm aufweisen. Ferner gibt es beispielsweise sogenannte Full-Height-Platinen, deren Slotblenden eine Höhe von 120 mm aufweisen. Je nachdem, ob eine Zusatzplatine gemäß dem Low-Profile- oder dem Full-Height-Formfaktor eingebaut werden soll, müssen die Gehäuse unterschiedliche Aussparungen zum Befestigen der Zusatzplatinen aufweisen. Dies hat einen hohen Produktionsaufwand zur Folge, da je nach Bedarf unterschiedliche Gehäuse produziert werden müssen. Außerdem führt dies zu einer geringen Flexibilität beim Nachrüsten von Zusatzkarten mit unterschiedlichen Formfaktoren.

Die WO 2015/007045 A1 bezieht sich auf ein Computergerät, insbesondere auf eine Struktur zur Installation von

Erweiterungskarten und einen All-in-One-Computer, gemäß dem Oberbegriff des Patentanspruchs 1.

CN 101 236 450 A bezieht sich auf Computer, und zwar insbesondere auf ein Computersystem, das Erweiterungskarten mit unterschiedlichen Höhenprofilen aufnehmen kann.

Aufgabe der vorliegenden Erfindung ist es, die oben genannten Probleme zu lösen oder zu mindern.

Gemäß einem ersten Aspekt wird die oben genannte Aufgabe durch ein Computersystem umfassend ein Gehäuse mit wenigstens einer Gehäusewand gelöst. Die wenigstens eine Gehäusewand weist eine erste Aussparung zur Anbringung einer ersten Zusatzplatine mit einem ersten Höhenprofil auf. Das Computersystem umfasst des Weiteren eine in dem Gehäuse angeordnete, sich senkrecht zu der wenigstens einen Gehäusewand erstreckende Systemplatine. Die erste Aussparung in der wenigstens einen Gehäusewand erstreckt sich senkrecht zu der Systemplatine. Außerdem umfasst das Computersystem eine Haltevorrichtung, die dazu eingerichtet ist, in der ersten Aussparung befestigt zu werden und eine zweite Zusatzplatine mit einem zweiten Höhenprofil parallel zu der Systemplatine in dem Computersystem zu befestigen. Die wenigstens eine Gehäusewand weist eine an die erste Aussparung anschließende Öffnung auf, in der ein sich parallel zur wenigstens einen Gehäusewand erstreckender Teil der Haltevorrichtung lagerbar ist. Die Öffnung ist dazu eingerichtet, mit einer Blende abgedeckt zu werden, wenn das Computersystem dazu eingerichtet ist, die erste Zusatzplatine mit dem ersten Höhenprofil in der ersten Aussparung anzubringen.

Vorteilhaft hierbei ist es, dass in der ersten Aussparung der Gehäusewand Zusatzplatinen mit unterschiedlichen Höhenprofilen befestigt werden können. Insbesondere können so sowohl Low-Profile-Platinen als auch Full-Height-Platinen in einer für Low-Profile-Platinen vorgesehenen Aussparung befestigt werden. Je nach Wunsch eines Benutzers des Computersystems kann eine entsprechende Zusatzplatine eingebaut werden, ohne dass unterschiedlich ausgestaltete Gehäuse angefertigt werden müssen.

Weiterhin weist die wenigstens eine Gehäusewand eine an die erste Aussparung anschließende Öffnung auf, in der ein sich parallel zur wenigstens einen Gehäusewand erstreckender Teil der Haltevorrichtung lagerbar ist. Die Öffnung ist dazu eingerichtet, mit einer Blende abgedeckt zu werden, wenn das Computersystem dazu eingerichtet ist, die erste Zusatzplatine mit dem ersten Höhenprofil in der ersten Aussparung anzubringen.

Beispielsweise eignen sich als Blende geschraubte oder geclipste Blechteile oder Kunststoffteile. Ein Vorteil einer derartigen Blende ist es, dass sie flexibel abgenommen und wieder angebracht werden kann, in Abhängigkeit davon, ob eine Zusatzplatine mit dem ersten oder dem zweiten Höhenprofil in dem Computersystem eingebaut ist.

In wenigstens einer Ausgestaltung entspricht eine Höhe der Haltevorrichtung senkrecht zu der Systemplatine einer Höhe der ersten Zusatzplatine. Ferner weist die Haltevorrichtung einen Befestigungsteil für die zweite Zusatzplatine auf, der an einem der Systemplatine abgewandten Ende der Haltevorrichtung angeordnet ist.

Ein Vorteil hierbei ist es, dass die zweite Zusatzplatine, welche parallel zu der Systemplatine in dem Computersystem befestigt werden kann, möglichst weit von der Systemplatine entfernt angebracht ist. Dies gewährleistet eine gute Kühlung der Systemplatine, der zweiten Zusatzplatine sowie weiterer in dem Computersystem angebrachter Komponenten. Außerdem wird auf diese Weise möglichst viel Platz zum Anbringen von Komponenten auf der Systemplatine gewährleistet, auch wenn die zweite Zusatzplatine in dem Computersystem eingebaut ist.

In wenigstens einer Ausgestaltung weist die wenigstens eine Gehäusewand wenigstens eine zweite Aussparung auf, die dazu eingerichtet ist, eine erste Zusatzplatine mit einem ersten Höhenprofil aufzunehmen, während in der ersten Aussparung die Haltevorrichtung befestigt ist.

So können verschiedene Zusatzplatinen mit unterschiedlichen Formfaktoren in dem Computersystem eingebaut werden. Insbesondere kann, zum Beispiel, eine Zusatzplatine gemäß dem Low-Profile-Standard und eine Zusatzplatine gemäß dem Full-Height-Standard eingebaut werden.

In wenigstens einer Ausgestaltung umfasst die wenigstens eine Gehäusewand einen an die erste Aussparung anschließenden ausbrechbaren Teil, der dazu eingerichtet ist, eine Öffnung freizugeben, in der ein sich parallel zur wenigstens einen Gehäusewand erstreckende Teil der Haltevorrichtung lagerbar ist.

Vorteilhaft hierbei ist es, dass ein Gehäuse mit einem solchen ausbrechbaren Teil verhältnismäßig einfach und kostengünstig zu produzieren ist.

Gemäß einem zweiten Aspekt wird die oben genannte Aufgabe durch eine Haltevorrichtung gelöst, die dazu eingerichtet ist, in einer in einer Gehäusewand eines Gehäuses eines Computersystems angeordneten Aussparung für eine erste Zusatzplatine mit einem ersten Höhenprofil befestigt zu werden und eine zweite Zusatzplatine mit einem zweiten Höhenprofil parallel zu einer in dem Gehäuse des Computersystems angeordneten Systemplatine in dem Computersystem zu befestigen.

Gemäß einem dritten Aspekt wird die oben genannte Aufgabe durch ein Montageverfahren für eine Zusatzplatine in einem Computersystem umfassend ein Gehäuse mit wenigstens einer Gehäusewand, wobei die wenigstens eine Gehäusewand eine erste Aussparung zur Anbringung einer ersten Zusatzplatine mit einem ersten Höhenprofil aufweist, wobei sich die erste Aussparung in der wenigsten einen Gehäusewand senkrecht zu einer in dem Gehäuse angeordnete, sich senkrecht zu der wenigstens einen Gehäusewand erstreckende Systemplatine erstreckt, gelöst. Das

Montageverfahren umfasst die folgenden Schritte:
- Entfernen eines an die erste Aussparung anschließenden entfernbaren Teils von der wenigstens einen Gehäusewand so dass sich eine Öffnung in der wenigstens einen ersten Gehäusewand ergibt;
- Befestigen einer Haltevorrichtung für eine zweite Zusatzplatine in der ersten Aussparung, so dass ein sich parallel zur wenigstens einen Gehäusewand erstreckender Teil der Haltevorrichtung in der Öffnung gelagert ist;
- Befestigen der zweiten Zusatzplatine mit einem zweiten Höhenprofil parallel zu einer in dem Gehäuse des Computersystems angeordnete Systemplatine an der Haltevorrichtung.

Vorteile des zweiten und dritten Aspekts entsprechen im Wesentlichen den Vorteilen des ersten Aspekts. Der entfernbare Teil der wenigstens einen Gehäusewand kann beispielsweise ein ausbrechbarer Teil sein, der aus der wenigstens einen Gehäusewand ausgebrochen wird, oder eine abnehmbare Blende sein, die beispielsweise aus Blech oder Kunststoff gefertigt ist und an der wenigstens einen Gehäusewand beispielsweise mittels Schrauben oder Clipverbindungen befestigbar ist.

Weitere vorteilhafte Ausgestaltungen sind in den angehängten Ansprüchen sowie der nachfolgenden Beschreibung der Figuren offenbart. In den Figuren werden für Elemente mit im Wesentlichen gleicher Funktion gleiche Bezugszeichen verwendet, diese Elemente müssen jedoch nicht in allen Einzelheiten identisch sein.

In den Figuren zeigen:
- Figur 1: eine perspektivische Darstellung eines Computersystems gemäß einem Ausführungsbeispiel der Erfindung in einer ersten Systemkonfiguration,
- Figur 2: eine perspektivische Darstellung des Computersystems gemäß dem Ausführungsbeispiel gemäß Figur 1 in einer zweiten Systemkonfiguration,
- Figur 3: eine teilweise explodierte Darstellung eines Ausschnitts des Computersystems gemäß der zweiten Systemkonfiguration gemäß Figur 2,
- Figur 4: einen Querschnitt eines Ausschnitts des Computersystems gemäß der zweiten Systemkonfiguration gemäß Figur 2, und
- Figur 5: einen Ausschnitt einer ersten Gehäusewand eines Computersystems gemäß einem Ausführungsbeispiel der Erfindung.

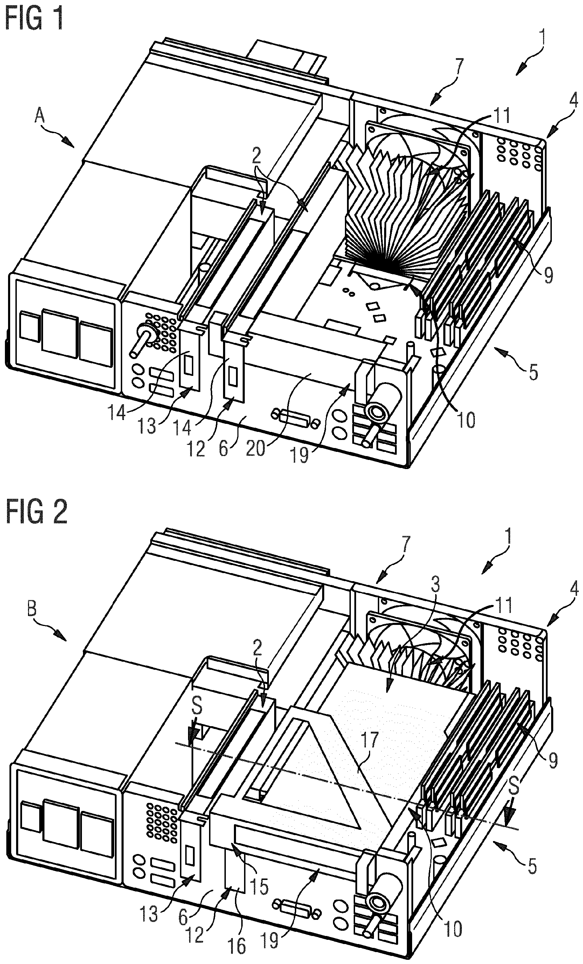

Die Figuren 1 und 2 zeigen jeweils eine perspektivische Ansicht eines Computersystems 1 gemäß einem Ausführungsbeispiel der Erfindung. Figur 1 zeigt das Computersystem 1 in einer ersten Systemkonfiguration A, Figur 2 zeigt das Computersystem 1 in einer zweiten Systemkonfiguration B. Die erste Systemkonfiguration A gemäß Figur 1 ist dadurch gekennzeichnet, dass zwei Low-Profile-Platinen 2 in dem Computersystem 1 eingebaut sind. Die zweite Systemkonfiguration B gemäß Figur 2 ist dadurch gekennzeichnet, dass eine Low-Profile-Platine 2 und eine Full-Height-Platine 3 in dem Computersystem 1 eingebaut sind.

Das Computersystem 1 gemäß der Figuren 1 und 2 umfasst jeweils ein Gehäuse 4. Das Gehäuse 4 ist in diesem Ausführungsbeispiel ein Gehäuse mit kleinem Formfaktor (englisch: small form factor, SFF), welches ein Volumen von ca. 8l fasst. Alternativ kann die hier beschriebene Erfindung natürlich auch in jedem beliebigen Computergehäuse verwendet werden. Das Gehäuse 4 weist einen Gehäuseboden 5 auf. An gegenüberliegenden Seitenkanten des Gehäusebodens 5 stehen senkrecht von dem Gehäuseboden 5 eine erste Gehäusewand 6 sowie eine zweite Gehäusewand 7 ab. Das Computersystem 1 ist mit einem hier nicht gezeigten Gehäusedeckel verschließbar.

Parallel zu dem Gehäuseboden 5 ist in dem Computersystem 1 eine Systemplatine 8 angebracht. Die Systemplatine 8 befindet sich in einem Bereich des Gehäusebodens 5 und ist an dem Gehäuseboden mittels hier nicht gezeigter Schrauben befestigt. Auf der Systemplatine 8 sind verschiedene Komponenten, wie beispielsweise Speichermodule 9, ein Prozessor 10, sowie ein Kühlkörper 11 angebracht.

In der ersten Gehäusewand 6 befinden sich eine erste Aussparung 12 und eine zweite Aussparung 13. Erste und zweite Aussparung 12, 13 erstrecken sich jeweils schlitzförmig von einem dem Gehäuseboden 5 abgewandten Ende der ersten Gehäusewand 6 senkrecht zu der Systemplatine 8.

Gemäß der ersten Systemkonfiguration A gemäß Figur 1 sind in der ersten und der zweiten Aussparung 12, 13 jeweils eine Low-Profile-Platine 2 befestigt. Die Low-Profile-Platinen 2 weisen jeweils eine Slotblende 14 auf, mittels der die Low-Profile-Platinen 2 in der ersten bzw. zweiten Aussparung 12, 13 befestigt sind. Die Low-Profile-Platinen 2 sind senkrecht zu der Systemplatine 8 angeordnet und auf die Systemplatine 8 gesteckt. Die Low-Profile-Platinen 2 weisen in diesem Ausführungsbeispiel unterschiedliche Längen auf. Alternativ können selbstverständlich auch gleich lange Low-Profile-Platinen 2 verwendet werden.

Gemäß der zweiten Systemkonfiguration B gemäß Figur 2 ist nur in der zweiten Aussparung 13 eine Low-Profile-Platine 2 befestigt. Gemäß der zweiten Systemkonfiguration B ist in der ersten Aussparung 12 eine Haltevorrichtung 15 für eine Full-Height-Platine 3 angebracht. Um in dem Computersystem 1 ausreichend Platz für die Full-Height-Platine 3 bereitzustellen weisen Kühlrippen des Kühlkörpers 11 entsprechende Aussparungen auf.

Die Haltevorrichtung 15 weist einen Befestigungsteil 16 auf, mittels dem die Haltevorrichtung 15 in der ersten Aussparung 12 befestigt ist. Außerdem weist die Haltevorrichtung 15 eine Platinenhalterung 17 auf, an der die Full-Height-Platine 3 mittels einer Slotblende 18 der Full-Height-Platine 3 an der Haltevorrichtung 15 befestigt ist. Die Platinenhalterung 17 ist über einer der Systemplatine 8 abgewandten Seite der Full-Height-Platine 3 in einer Dreiecksform ausgestaltet, was einer Verstärkung und einem Schutz der Platine 3 dient.

Die Platinenhalterung 17 ist in einer Öffnung 19 der ersten Gehäusewand 6 gelagert. Die Öffnung 19 schließt sich an die erste Aussparung 12 an und ist an einem dem Gehäuseboden 5 abgewandten Ende der ersten Gehäusewand 6 offen. Die Öffnung 19, in der die Platinenhalterung 17 gelagert ist, erstreckt sich parallel zu der Systemplatine 8, senkrecht zu der ersten und zweiten Aussparung 12, 13. Demzufolge ist die Slotblende 18 der Full-Height-Platine 3, und somit auch die Full-Height-Platine selbst, parallel zu der Systemplatine 8 in dem Computersystem 1 befestigt.

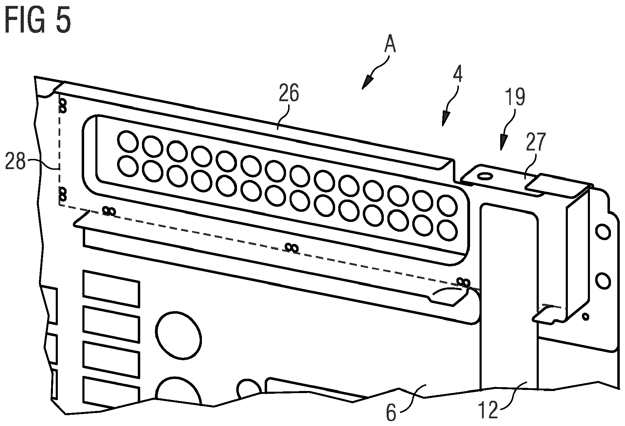

Die Öffnung 19 ist in der ersten Systemkonfiguration A gemäß Figur 1 durch einen abnehmbaren Teil 20 der ersten Gehäusewand 6 abgedeckt. Der abnehmbare Teil 20 ist an der restlichen ersten Gehäusewand 6 mittels hier nicht gezeigter Schrauben befestigt. Alternativ kann der abnehmbare Teil 20 auch an der restlichen ersten Gehäusewand 6 mittels einer Clipverbindung befestigt sein. Somit kann der abnehmbare Teil 20 von der restlichen ersten Gehäusewand 6 getrennt und an dieser wieder befestigt werden. Dies ermöglicht ein flexibles wechseln zwischen der ersten Systemkonfiguration A und der zweiten Systemkonfiguration B. Der abnehmbare Teil 20 stellt eine Blende dar, die beispielsweise aus Blech gefertigt ist und die Öffnung 19 gegen elektromagnetische Strahlung abdichtet. Die Blende kann alternativ auch aus Kunststoff gefertigt sein. Eine alternative Ausgestaltung hierzu wird mit Bezug auf Figur 5 beschrieben. Durch den abnehmbaren Teil 20 wird in der ersten Systemkonfiguration A ein Inneres des Gehäuses 4, in einem Bereich der Öffnung 19, vor eindringenden Staub geschützt, sowie das Gehäuse 4 gegenüber elektromagnetischer Strahlung geschirmt.

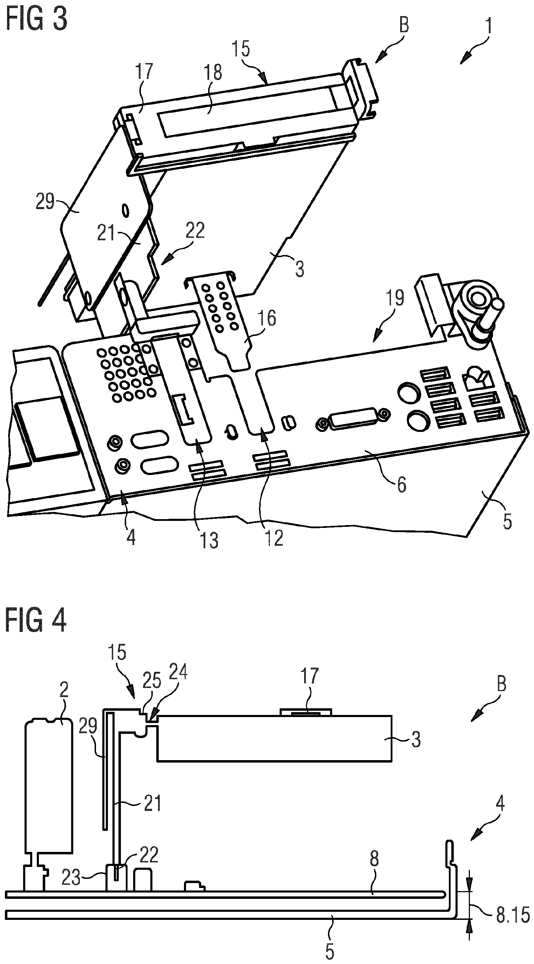

Weitere Details bezüglich der Haltevorrichtung 15 werden mit Bezug auf die Figuren 3 und 4 beschrieben.

Figur 3 zeigt eine teilweise explodierte Darstellung eines Ausschnitts des Computersystems 1 gemäß dem Ausführungsbeispiel gemäß den Figuren 1 und 2 in der zweiten Systemkonfiguration B. Der Ausschnitt in Figur 3 zeigt den Gehäuseboden 5 sowie einen Teil der ersten Gehäusewand 6 mit der zweiten Aussparung 13 und der ersten Aussparung 12 mit der Haltevorrichtung 15.

Der Befestigungsteil 16, mit dem die Haltevorrichtung 15 in der ersten Aussparung 12 befestigt wird, gleicht im Wesentlichen einem unteren Ende einer Slotblende einer Low-Profile-Platine 2 und ist mittels hier nicht gezeigter Schrauben an der Platinenhalterung 17 der Haltevorrichtung 15 befestigt. Alternativ ist der Befestigungsteil 16 nicht mittels Schrauben an der Platinenhalterung 17 befestigt, sondern beispielsweise über eine Steckverbindung oder lediglich über einen Auflagekontakt lose mit der Platinenhalterung 17 verbunden.

Der Befestigungsteil 16 dient unter anderem dazu, die erste Aussparung 12 gegen elektromagnetische Strahlung abzudichten, wenn die Haltevorrichtung 15 in der ersten Aussparung 12 angebracht ist. Des Weiteren ist es möglich, in dem Befestigungsteil 16 eine I/O-Schnittstelle (Input/Output-Schnittstelle), beispielsweise eine Buchse für eine Datenschnittstelle, anzuordnen. Diese I/O-Schnittstelle kann eine I/O-Schnittstelle, die an die Full-Height-Platine 3 angeschlossen ist, oder eine sonstige I/O-Schnittstelle des Computersystems 1 sein.

In der Figur 3 ist des Weiteren ein Anschlussteil 21 der Haltevorrichtung 15 zu sehen. Dieser Anschlussteil 21 erstreckt sich senkrecht zu der Full-Height-Platine 3 in Richtung Systemplatine 8. Im eingebauten Zustand liegt der Anschlussteil 21 parallel zu der Low-Profile-Platine 2, wie sie in Figur 2 gezeigt ist. Der Anschlussteil 21 stellt für die Full-Height-Platine 3 eine sogenannte Riser-Karte dar.

An einem der Systemplatine 8 zugewandten Ende des Anschlussteils 21 weist der Anschlussteil 21 einen Steckverbinder 22 gemäß dem PCI- bzw. PCIe-Standard auf, sodass der Anschlussteil 21 mit dem Steckverbinder 22 in einen dafür vorgesehenen Gegensteckverbinder auf der Systemplatine 8 eingesteckt werden kann. Dies wird im Folgenden näher mit Bezug auf Figur 4 erläutert.

Figur 4 zeigt einen Schnitt durch das Computersystem 1 gemäß dem Ausführungsbeispiel gemäß der Figuren 1 und 2 in der zweiten Systemkonfiguration B. Figur 5 zeigt eine Schnittebene parallel zur ersten Gehäusewand 6 entlang einer in der Figur 2 gezeigten Schnittlinie S.

In der Schnittdarstellung gemäß Figur 4 ist ein Teil des Gehäusebodens 5 und der Systemplatine 8 gezeigt. Außerdem zeigt Figur 5 die Low-Profile-Platine 2 sowie die Full-Height-Platine 3, die in der Platinenhalterung 17 gelagert ist. Des Weiteren ist der senkrecht auf die Systemplatine 8 stehende Anschlussteil 21 gezeigt. In Figur 4 ist links neben dem Anschlussteil 21 ferner eine Montageplatte 29 gezeigt, die Teil einer mechanischen Befestigung der Haltevorrichtung 15 ist.

Figur 4 zeigt ferner den Steckverbinder 22 des Anschlussteils 21, der in den Gegensteckverbinder 23 auf der Systemplatine 8 gesteckt ist. Der Gegensteckverbinder 23, der den Steckverbinder 22 in der zweiten Systemkonfiguration B aufnimmt, nimmt in der ersten Systemkonfiguration A einen entsprechenden Steckverbinder der Low-Profile-Platine, die in der ersten Aussparung befestigt ist, auf.

An einem der Full-Height-Platine 3 zugewandten Ende des Anschlussteils 21 weist dieser einen Gegensteckverbinder 25 gemäß dem PCI- bzw. PCIe-Standard auf. In diesen Gegensteckverbinder 25 des Anschlussteils 21 wird ein entsprechender Steckverbinder 24 der Full-Height-Platine 3 eingesteckt. Auf diese Weise wird eine elektrische Verbindung für Versorgungsspannungen, Signale, etc. zwischen der Systemplatine 8 und der Full-Height-Platine 3 über den Anschlussteil 21 hergestellt.

Figur 5 zeigt einen Ausschnitt der ersten Gehäusewand 6 in einem Bereich der Öffnung 19 mit einem Teil der ersten Aussparung 12. Figur 5 zeigt einen Blick auf die erste Gehäusewand 6 aus einem Inneren des Gehäuses 4 des Computersystems 1. Figur 5 zeigt eine alternative Ausgestaltung zu dem abnehmbaren Teil 20 und der Öffnung 19. Der in Figur 5 gezeigte Zustand entspricht der ersten Systemkonfiguration A, gemäß der eine Low-Profile-Platine 2 in der ersten Aussparung 12 befestigbar ist.

Die Öffnung 19 ist in diesem Ausführungsbeispiel mit einem ausbrechbaren Teil 26 abgedeckt. Der ausbrechbare Teil 26 weist an einem Randbereich der ersten Gehäusewand 6 eine Lasche 27 auf, an der eine Slotblende 14 einer Low-Profile-Platine 2 befestigt werden kann. Soll in dem Gehäuse 4 eine Full-Height-Platine 3 in der ersten Aussparung 12 eingebaut werden, so kann der ausbrechbare Teil 26 aus der Gehäusewand 6 ausgebrochen werden. Hierfür weist die Gehäusewand 6 eine Sollbruchlinie 28 auf, entlang der der ausbrechbare Teil 26 von der ersten Gehäusewand 6 gelöst werden kann.

Zusätzlich zeigt Figur 5 einen entlang einer Oberkante der Öffnung 19 angebrachten Vorsprung. Dieser Vorsprung weist ins Innere des Gehäuses 4 und stellt eine Auflage für die Haltevorrichtung 15 dar. Dieser Vorsprung kann identisch in dem Ausführungsbeispiel gemäß der Figuren 1 bis 4 verwendet werden.

Die in den Figuren gezeigten Ausführungsbeispiele umfassend jeweils eine erste und eine zweite Aussparung 12, 13 sind lediglich beispielhaft zu verstehen. Alternativ kann das Gehäuse 4 bzw. die erste Gehäusewand 6 auch nur die erste Aussparung 12 oder weitere, der ersten bzw. der zweiten Aussparung 12, 13 ähnliche Aussparungen aufweisen.

### Bezugszeichenliste

- 1: Computersystem
- 2: Low-Profile-Platine
- 3: Full-Height-Platine
- 4: Gehäuse
- 5: Gehäuseboden
- 6: erste Gehäusewand
- 7: zweiter Gehäusewand
- 8: Systemplatine
- 9: Speichermodul
- 10: Prozessor
- 11: Kühlkörper
- 12: erste Aussparung
- 13: zweite Aussparung
- 14: Slotblende der Low-Profile-Platine
- 15: Haltevorrichtung
- 16: Befestigungsteil
- 17: Platinenhalterung
- 18: Slotblende der Full-Height-Platine
- 19: Öffnung
- 20: abnehmbarer Teil
- 21: Anschlussteil
- 22: Steckverbinder
- 23: Gegensteckverbinder
- 24: Steckverbinder
- 25: Gegensteckverbinder
- 26: ausbrechbarer Teil
- 27: Lasche
- 28: Sollbruchlinie
- 29: Montageplatte
- A: erste Systemkonfiguration
- B: zweite Systemkonfiguration
- S: Schnittlinie

## Patentansprüche

1. Computersystem (1), umfassend
- ein Gehäuse (4) mit wenigstens einer Gehäusewand (6), wobei die wenigstens eine Gehäusewand (6) eine erste Aussparung (12) zur Anbringung einer ersten Zusatzplatine mit einem ersten Höhenprofil aufweist;
- eine in dem Gehäuse (4) angeordnete, sich senkrecht zu der wenigstens einen Gehäusewand (6) erstreckende Systemplatine (8), wobei sich die erste Aussparung (12) in der wenigstens einen Gehäusewand (6) senkrecht zu der Systemplatine (8) erstreckt;
- eine Haltevorrichtung (15), die dazu eingerichtet ist, in der ersten Aussparung (12) befestigt zu werden und eine zweite Zusatzplatine mit einem zweiten Höhenprofil parallel zu der Systemplatine (8) in dem Computersystem (1) zu befestigen; **dadurch gekennzeichnet, dass** die wenigstens eine Gehäusewand (6) eine an die erste Aussparung (12) anschließende Öffnung (19) aufweist, in der ein sich parallel zur wenigstens einen Gehäusewand (6) erstreckender Teil der Haltevorrichtung (15) lagerbar ist, und wobei die Öffnung (19) dazu eingerichtet ist, mit einer Blende abgedeckt zu werden, wenn das Computersystem (1) dazu eingerichtet ist, die erste Zusatzplatine mit dem ersten Höhenprofil in der ersten Aussparung (12) anzubringen.

2. Computersystem (1) gemäß Anspruch 1, wobei die erste Zusatzplatine und die zweite Zusatzplatine jeweils PCI- und/oder PCIe-Platinen sind.

3. Computersystem (1) gemäß Anspruch 2, wobei
- die erste Zusatzplatine eine Low-Profile-Platine (2) ist,
- die zweite Zusatzplatine eine Full-Height-Platine (3) ist, und
- die erste Aussparung (12) ein Low-Profile-Slot ist.

4. Computersystem (1) gemäß einem der Ansprüche 1 bis 3, wobei eine Höhe der Haltevorrichtung (15) senkrecht zu der Systemplatine (8) einer Höhe der ersten Zusatzplatine entspricht und die Haltevorrichtung (15) ein Befestigungsteil (16) für die zweite Zusatzplatine aufweist, der an einem der Systemplatine (8) abgewandten Ende der Haltevorrichtung (15) angeordnet ist.

5. Computersystem (1) gemäß einem der Ansprüche 1 bis 4, wobei die wenigstens eine Gehäusewand (6) wenigstens eine zweite Aussparung (13) aufweist, die dazu eingerichtet ist, eine erste Zusatzplatine mit einem ersten Höhenprofil aufzunehmen, während in der ersten Aussparung (12) die Haltevorrichtung (15) befestigt ist.

6. Computersystem (1) gemäß einem der Ansprüche 1 bis 5, wobei die Haltevorrichtung (15) einen Anschlussteil (21) umfasst, der sich senkrecht zu der Systemplatine (8) und der wenigstens einen Gehäusewand (6) erstreckt und dazu eingerichtet ist, eine elektrische Verbindung zwischen der Systemplatine (8) und der zweiten Zusatzplatine herzustellen.

7. Computersystem (1) gemäß einem der Ansprüche 1 bis 6, wobei die wenigstens eine Gehäusewand (6) einen an die erste Aussparung (12) anschließenden ausbrechbaren Teil (26) umfasst, der dazu eingerichtet ist, eine Öffnung (19) freizugeben, in der ein sich parallel zur wenigstens einen Gehäusewand (6) erstreckender Teil der Haltevorrichtung (15) lagerbar ist.

8. Montageverfahren für eine Zusatzplatine in einem Computersystem (1) umfassend ein Gehäuse (4) mit wenigstens einer Gehäusewand (6), wobei die wenigstens eine Gehäusewand (6) eine erste Aussparung (12) zur Anbringung einer ersten Zusatzplatine mit einem ersten Höhenprofil aufweist, wobei sich die erste Aussparung in der wenigsten einen Gehäusewand senkrecht zu einer in dem Gehäuse angeordnete, sich senkrecht zu der wenigstens einen Gehäusewand erstreckende Systemplatine erstreckt, das Montageverfahren umfassend die folgenden Schritte:
- Entfernen eines an die erste Aussparung (12) anschließenden entfernbaren Teils von der wenigstens einen Gehäusewand (6) so dass sich eine Öffnung (19) in der wenigstens einen ersten Gehäusewand (6) ergibt;
- Befestigen einer Haltevorrichtung (15) für eine zweite Zusatzplatine in der ersten Aussparung (12), so dass ein sich parallel zur wenigstens einen Gehäusewand (6) erstreckender Teil der Haltevorrichtung (15) in der Öffnung (19) gelagert ist;
- Befestigen der zweiten Zusatzplatine mit einem zweiten Höhenprofil parallel zur in dem Gehäuse (4) des Computersystems (1) angeordnete Systemplatine (8) an der Haltevorrichtung (15).

## Claims

1. A computer system (1) comprising
- a housing (4) having at least one housing wall (6), the at least one housing wall (6) having a first recess (12) for mounting a first add-on board having a first height profile
- a system board (8) arranged in the housing (4) and extending perpendicular to the at least one housing wall (6), wherein the first recess (12) in the at least one housing wall (6) extends perpendicular to the system board (8);
- a mounting device (15) adapted to be mounted in the first recess (12) and to mount a second add-on board having a second height profile parallel to the system board (8) in the computer system (1),
**Characterized in that** the at least one housing wall (6) comprises an opening (19) adjoining the first recess (12), in which opening (19) a part of the holding device (15) extending parallel to the at least one housing wall (6) can be arranged, and wherein the opening (19) is arranged to be covered with a blind if the computer system (1) is arranged to mount the first add-on board having the first height profile in the first recess (12) .

2. Computer system (1) according to claim 1, wherein the first add-on board and the second add-on board respectively are PCI and/or PCIe boards.

3. Computer system (1) according to claim 2, wherein
- the first add-on board is a low-profile board (2),
- the second add-on board is a full-height board (3), and
- the first recess (12) is a low-profile slot.

4. Computer system (1) according to any one of claims 1 to 3, wherein a height of the mounting device (15) perpendicular to the system board (8) corresponds to a height of the first add-on board, and the mounting device (15) comprises a fastening part (16) for the second add-on board, which is arranged at an end of the mounting device (15) facing away from the system board (8).

5. Computer system (1) according to any one of claims 1 to 4, wherein the at least one housing wall (6) comprises at least one second recess (13) arranged to receive a first add-on board having a first height profile, while the mounting device (15) is mounted in the first recess (12).

6. Computer system (1) according to any one of claims 1 to 5, wherein the mounting device (15) comprises a connecting part (21) extending perpendicularly to the system board (8) and the at least one housing wall (6), and adapted to establish an electrical connection between the system board (8) and the second add-on board.

7. Computer system (1) according to any one of claims 1 to 6, wherein the at least one housing wall (6) comprises a break-off part (26) adjoining the first recess (12), the break-off part being arranged to expose an opening (19) in which a part of the holding device (15) extending parallel to the at least one housing wall (6) can be mounted.

8. Method for mounting an add-on board in a computer system (1) comprising a housing (4) with at least one housing wall (6), the at least one housing wall (6) comprising a first recess (12) for mounting a first add-on board with a first height profile, wherein the first recess in the at least one housing wall extends perpendicular to a system board arranged in the housing, the system board extending perpendicular to the at least one housing wall, the method comprising the following steps:
- removing a removable part adjacent to the first recess (12) from the at least one housing wall (6) such that an opening (19) is formed in the at least one first housing wall (6);
- mounting a mounting device (15) for a second add-on board in the first recess (12) so that a part of the mounting device (15) extending parallel to the at least one housing wall (6) is mounted in the opening (19);
- mounting the second add-on board with a second height profile to the mounting device (15) in parallel to the system board (8) arranged in the housing (4) of the computer system (1).

## Revendications

1. Système informatique (1), comprenant
- un boîtier (4) présentant au moins une paroi de boîtier (6), sachant que l'au moins une paroi de boîtier (6) présente une première réservation (12) destinée à placer une première platine supplémentaire présentant un premier profil de hauteur ;
- une platine système (8) disposée dans le boîtier (4), s'étendant perpendiculairement à l'au moins une paroi de boîtier (6), sachant que la première réservation (12) s'étend dans l'au moins une paroi de boîtier (6) perpendiculairement à la platine système (8) ;
- un dispositif de maintien (15) qui est configuré pour être fixé dans la première réservation (12) et pour fixer une deuxième platine supplémentaire présentant un deuxième profil de hauteur parallèlement à la platine système (8) dans le système informatique (1) ; **caractérisé en ce que** l'au moins une paroi de boîtier (6) présente une ouverture (19) faisant suite à la première réservation (12), dans laquelle une partie du dispositif de maintien (15) s'étendant parallèlement à l'au moins une paroi de boîtier (6) est stockable, et sachant que l'ouverture (19) est configurée pour être recouverte d'un cache lorsque le système informatique (1) est configuré pour placer la première platine supplémentaire présentant le premier profil de hauteur dans la première réservation (12).

2. Système informatique (1) selon la revendication 1, sachant que la première platine supplémentaire et la deuxième platine supplémentaire sont respectivement des platines PCI et/ou PCIe.

3. Système informatique (1) selon la revendication 2, sachant que
- la première platine supplémentaire est une platine à profil bas (Low-Profile) (2),
- la deuxième platine supplémentaire est une platine à pleine hauteur (Full-Height) (3), et
- la première réservation (12) est un emplacement à profil bas (Low-Profile).

4. Système informatique (1) selon l'une des revendications 1 à 3, sachant qu'une hauteur du dispositif de maintien (15) perpendiculairement à la platine système (8) correspond à une hauteur de la première platine supplémentaire et le dispositif de maintien (15) présente une partie de fixation (16) pour la deuxième platine supplémentaire, qui est disposée à une extrémité du dispositif de maintien (15) opposée à la platine système (8).

5. Système informatique (1) selon l'une des revendications 1 à 4, sachant que l'au moins une paroi de boîtier (6) présente au moins une deuxième réservation (13) qui est configurée pour loger une première platine supplémentaire présentant un premier profil de hauteur, tandis que le dispositif de maintien (15) est fixé dans la première réservation (12).

6. Système informatique (1) selon l'une des revendications 1 à 5, sachant que le dispositif de maintien (15) comprend une partie de raccordement (21) qui s'étend perpendiculairement à la platine système (8) et à l'au moins une paroi de boîtier (6) et est configurée pour établir une connexion électrique entre la platine système (8) et la deuxième platine supplémentaire.

7. Système informatique (1) selon l'une des revendications 1 à 6, sachant que l'au moins une paroi de boîtier (6) comprend une partie détachable (26) faisant suite à la première réservation (12), qui est configurée pour libérer une ouverture (19) dans laquelle une partie du dispositif de maintien (15) s'étendant parallèlement à l'au moins une paroi de boîtier (6) est stockable.

8. Procédé de montage pour une platine supplémentaire dans un système informatique (1) comprenant un boîtier (4) présentant au moins une paroi de boîtier (6), sachant que l'au moins une paroi de boîtier (6) présente une première réservation (12) destinée à placer une première platine supplémentaire présentant un premier profil de hauteur, sachant que la première réservation s'étend dans l'au moins une première paroi de boîtier perpendiculairement à une platine système disposée dans le boîtier et s'étendant perpendiculairement à l'au moins une paroi de boîtier, le procédé de montage comprenant les étapes suivantes :
- enlèvement d'une partie de l'au moins une paroi de boîtier (6) qui est enlevable et fait suite à la première réservation (12), de sorte qu'une ouverture (19) soit ménagée dans l'au moins une paroi de boîtier (6) ;
- fixation d'un dispositif de maintien (15) pour une deuxième platine supplémentaire dans la première réservation (12) de sorte qu'une partie du dispositif de maintien (15) s'étendant parallèlement à l'au moins une paroi de boîtier (6) soit stockée dans l'ouverture (19) ;
- fixation de la deuxième platine supplémentaire présentant un deuxième profil de hauteur au dispositif de maintien (15) parallèlement à la platine système (8) disposée dans le boîtier (4) du système informatique (1).
